# EUROPEAN PATENT SPECIFICATION

(11) **EP 3 983 222 B1**
(45) Date of publication and mention of the grant of the patent: **30.07.2025**
(21) Application number: 20737606.2
(22) Date of filing: 11.06.2020
(51) Int. Cl.: B33Y 50/00, G06F 30/10

(54) **SYSTEM AND METHOD FOR 3D PRINTING A SUPPORT STRUCTURE**
SYSTEM UND VERFAHREN ZUM 3D-DRUCKEN EINER STÜTZSTRUKTUR
SYSTÈME ET MÉTHODE POUR L'IMPRESSION 3D D'UNE STRUCTURE DE SUPPORT

(30) Priority: 13.06.2019 US 201962860894 P
(43) Date of publication of application: 20.04.2022
(73) Proprietor: Stratasys Ltd., 7670402 Rehovot (IL)
(72) Inventor: ARAD, Nur, 6296809 Tel-Aviv (IL)
(74) Representative: Pearl Cohen Zedek Latzer Baratz UK LLP
(86) International application number: PCT/IL2020/050649
(87) International publication number: WO 2020/250229

(56) References cited:
- WO-A1-2009/047355
- WO-A1-2015/145346
- WO-A1-2018/044399
- US-A1- 2014 300 017
- US-A1- 2018 169 954
- KROL T A ET AL: "Verification of Structural Simulation Results of Metal-based Additive Manufacturing by Means of Neutron Diffraction", PHYSICS PROCEDIA, ELSEVIER, AMSTERDAM, NL, vol. 41, 9 April 2013 (2013-04-09), pages 842 - 850, XP028544778, ISSN: 1875-3892, DOI: 10.1016/J.PHPRO.2013.03.158
- WADEA AMEEN ET AL: "Manufacturability of Overhanging Holes Using Electron Beam Melting", METALS, vol. 8, no. 6, 30 May 2018 (2018-05-30), pages 1 - 24, XP055736680, DOI: 10.3390/met8060397
- TONY A. KROL ET AL: "OPTIMIZATION OF SUPPORTS IN METAL-BASED ADDITIVE MANUFACTURING BY MEANS OF FINITE ELEMENT MODELS", PHYSICS PROCEDIA, vol. 23, 6 August 2012 (2012-08-06), AMSTERDAM, NL, pages 707 - 718, XP055573366, ISSN: 1875-3892
- "University of Louisville", 1 January 2015, article KAI ZENG: "Optimization of support structures for selective laser melting", XP055574173, DOI: 10.18297/etd/2221
- WADEA AMEEN ET AL: "Manufacturability of Overhanging Holes Using Electron Beam Melting", METALS, vol. 8, no. 6, 30 May 2018 (2018-05-30), pages 1 - 24, XP055736680, DOI: 10.3390/met8060397
- TONY A. KROL ET AL: "OPTIMIZATION OF SUPPORTS IN METAL-BASED ADDITIVE MANUFACTURING BY MEANS OF FINITE ELEMENT MODELS", PHYSICS PROCEDIA, vol. 23, 6 August 2012 (2012-08-06), AMSTERDAM, NL, pages 707 - 718, XP055573366, ISSN: 1875-3892
- "University of Louisville", 1 January 2015, article KAI ZENG: "Optimization of support structures for selective laser melting", XP055574173, DOI: 10.18297/etd/2221

## Description

### FIELD OF THE INVENTION

The present invention relates to the field of three-dimensional (3D) inkjet printing, and more particularly, to support structures for printing three-dimensional objects.

### BACKGROUND OF THE INVENTION

In three-dimensional (3D) inkjet printing of a 3D object, material is selectively jetted from one or more print heads and deposited onto a fabrication tray in consecutive layers according to a pre-determined configuration as defined by a software file. Some deposition processes include depositing different materials in order to form a single object or model. For example, an object may be built by depositing a first material for forming the body structure and a second material for forming a support structure to support various sections of the body structure, for example, negative angle surfaces and overhangs. The support structure is later removed by mechanical, chemical or other means to reveal the final object. The article "Manufacturability of Overhanging Holes Using Electron Beam Melting" by Wadea Ameen et al. represents relevant background art.

### SUMMARY OF THE INVENTION

The invention is defines by the appended claims. Some embodiments of the present invention may provide a method of defining at least one support structure for at least one 3D object to be printed using a 3D printing system, the method comprising: receiving a 3D digital model of at least one 3D object to be printed; slicing the 3D digital model to generate multiple slices, wherein each of at least some of the multiple slices includes at least one body region that represents a respective horizontal cross-section of the at least one 3D object; identifying at least one slice of the multiple slices that includes at least one body region that has to be supported by at least one support structure when printing the at least one 3D object; determining whether the at least one body region in the at least one identified slice meets a predetermined set of rules; if the at least one body region in the at least one identified slice does not meet the predetermined set of rules, defining at least one default support structure for the at least one body region in the at least one identified slice; and if the at least one body region in the at least one identified slice meets the predetermined set of rules, defining at least one improved support structure for the at least one body region in the at least one identified slice.

In some embodiments, the at least one improved support structure is at least one of occupies less space on a fabrication tray of the 3D printing system and requires less supporting material than the at least one default support structure.

In some embodiments, defining the at least one improved support structure comprises: selecting a subset of preceding slices of the multiple slices that precede the at least one identified slice, wherein each of the slices of the subset of preceding slices has to include at least one support region to be filled with a supporting material when printing the at least one 3D object, to thereby form the at least one support structure needed to support the at least one body region in the at least one identified slice; and defining at least one support region for each slice of the subset of preceding slices such that a width of the at least one support region in the subset of preceding slices gradually increases between a last slice in the subset that is adjacent to the at least one identified slice and a first slice in the subset.

In some embodiments, determining that the at least one body region in the at least one identified slice meets the predetermined set of rules comprises: determining that a width of the at least one body region in the at least one identified slice is smaller than a specified width threshold.

In some embodiments, determining that the at least one body region in the at least one identified slice meets the predetermined set of rules comprises: determining that a distance between the at least one body region in the at least one identified slice and at least one body region in one of preceding slices immediately below the at least one body region in the at least one identified slice or the fabrication tray is larger than a specified distance threshold.

In some embodiments, determining that the at least one body region in the at least one identified slice meets the predetermined set of rules comprises: determining that a length of the at least one body region in the at least one identified slice is larger than a specified length threshold.

In some embodiments, determining that the at least one body region in the at least one identified slice meets the predetermined set of rules comprises: determining that there are no body regions in at least one slices that are subsequent to the at least one identified slice that is wider than the at least one body region in the at least one identified slice.

In some embodiments, the method comprising: determining if the at least one improved support structure defined for the at least one 3D object obstruct the construction of at least one other 3D object on the fabrication tray; and if so, modifying a location of one or more of the at least one 3D object and the at least one another 3D object on the fabrication tray to avoid the obstruction thereof.

Some embodiments of the present invention may provide a system for defining at least one support structure for at least one 3D object for printing thereof using a 3D printing system, the system comprising: a slicing module configured to: receive a 3D digital model of at least one 3D object to be printed using a 3D printing system; and slice the 3D digital model to generate multiple slices, wherein each of at least some of the multiple slices includes at least one body region that represents a respective horizontal cross-section of the at least one 3D object; and a support structure definition module configured to: identify at least one slice of the multiple slices that includes at least one body region that has to be supported by at least one support structure when printing the at least one 3D object; determine whether the at least one body region in the at least one identified slice meets a predetermined set of rules; if the at least one body region in the at least one identified slice does not meet a predetermined set of rules, define at least one default support structure for the at least one body region in the at least one identified slice; and if the at least one body region in the at least one identified slice meets the predetermined set of rules, define at least one improved support structure for the at least one body region in the at least one identified slice.

In some embodiments, the at least one improved support structure is at least one of occupies less space on a fabrication tray of the 3D printing system and requires less supporting material than the at least one default support structure.

In some embodiments, in order to define the at least one improved support structure, the support structure definition module is configured to: select a subset of preceding slices of the multiple slices that precede the at least one identified slice, wherein each of the slices of the subset of preceding slices has to include at least one support region to be filled with a supporting material when printing the at least one 3D object, to thereby form the at least one support structure needed to support the at least one body region in the at least one identified slice; and define at least one support region for each slice of the subset of preceding slices such that a width of the at least one support region in the subset of preceding slices gradually increases between a last slice in the subset that is adjacent to the at least one identified slice and a first slice in the subset.

In some embodiments, in order to determine that the at least one body region in the at least one identified slice meets the predetermined set of rules, the support structure definition module is configured to: determine that a width of the at least one body region in the at least one identified slice is smaller than a specified width threshold.

In some embodiments, in order to determine that the at least one body region in the at least one identified slice meets the predetermined set of rules, the support structure definition module is configured to: determine that a distance between the at least one body region in the at least one identified slice and at least one body region in one of preceding slices immediately below the at least one body region in the at least one identified slice or the fabrication tray is larger than a specified distance threshold.

In some embodiments, in order to determine that the at least one body region in the at least one identified slice meets the predetermined set of rules, the support structure definition module is configured to: determine that a length of the at least one body region in the at least one identified slice is larger than a specified length threshold.

In some embodiments, in order to determine that the at least one body region in the at least one identified slice meets the predetermined set of rules, the support structure definition module is configured to: determine that there are no body regions in at least one of slices that are subsequent to the at least one identified slice that are wider than the at least one body region in the at least one identified slice.

In some embodiments, the slicing module is configured to: determine whether the at least one improved support structure defined for the at least one 3D object obstructs the construction of at least one other 3D object on the fabrication tray; and if so, modify a location of one or more of the at least one 3D object and the at least one another 3D object on the fabrication tray to avoid the obstruction thereof.

These, additional, and/or other aspects and/or advantages of the present invention are set forth in the detailed description which follows, possibly inferable from the detailed description, and/or learnable by practice of the present invention.

### BRIEF DESCRIPTION OF THE DRAWINGS

For a better understanding of embodiments of the invention and to show how the same can be carried into effect, reference will now be made, purely by way of example, to the accompanying drawings in which like numerals designate corresponding elements or sections throughout.

In the accompanying drawings:
**Fig. 1** is a schematic illustration of a 3D printing system for printing 3D objects, according to some embodiments of the invention;
**Figs. 2A-2D** are schematic illustrations of various options of printing a 3D object using a 3D printing system;
**Fig. 3** is a schematic block diagram of a system for defining at least one support structure for at least one 3D object to be printed using a 3D printing system, according to some embodiments of the invention;
**Figs. 4A** and **4B** show different examples of defining at least one support structure for at least one 3D object to be printed using a 3D printing system, according to some embodiments of the invention; and
**Fig. 5** is a flowchart of a method of defining at least one support structure for at least one 3D object to be printed using a 3D printing system, according to some embodiments of the invention.

It will be appreciated that, for simplicity and clarity of illustration, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

### DETAILED DESCRIPTION OF THE INVENTION

In the following description, various aspects of the present invention are described. For purposes of explanation, specific configurations and details are set forth in order to provide a thorough understanding of the present invention. However, it will also be apparent to one skilled in the art that the present invention can be practiced without the specific details presented herein. Furthermore, well known features can have been omitted or simplified in order not to obscure the present invention. With specific reference to the drawings, it is stressed that the particulars shown are by way of example and for purposes of illustrative discussion of the present invention only and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention can be embodied in practice.

Before at least one embodiment of the invention is explained in detail, it is to be understood that the invention is not limited in its application to the details of structure and the arrangement of the components set forth in the following description or illustrated in the drawings. The invention is applicable to other embodiments that can be practiced or carried out in various ways as well as to combinations of the disclosed embodiments. Also, it is to be understood that the phraseology and terminology employed herein is for the purpose of description and should not be regarded as limiting.

Unless specifically stated otherwise, as apparent from the following discussions, it is appreciated that throughout the specification discussions utilizing terms such as "processing", "computing", "calculating", "determining", "enhancing" or the like, refer to the action and/or processes of a computer or computing system, or similar electronic computing device, that manipulates and/or transforms data represented as physical, such as electronic, quantities within the computing system's registers and/or memories into other data similarly represented as physical quantities within the computing system's memories, registers or other such information storage, transmission or display devices. Any of the disclosed modules or units can be at least partially implemented by a computer processor.

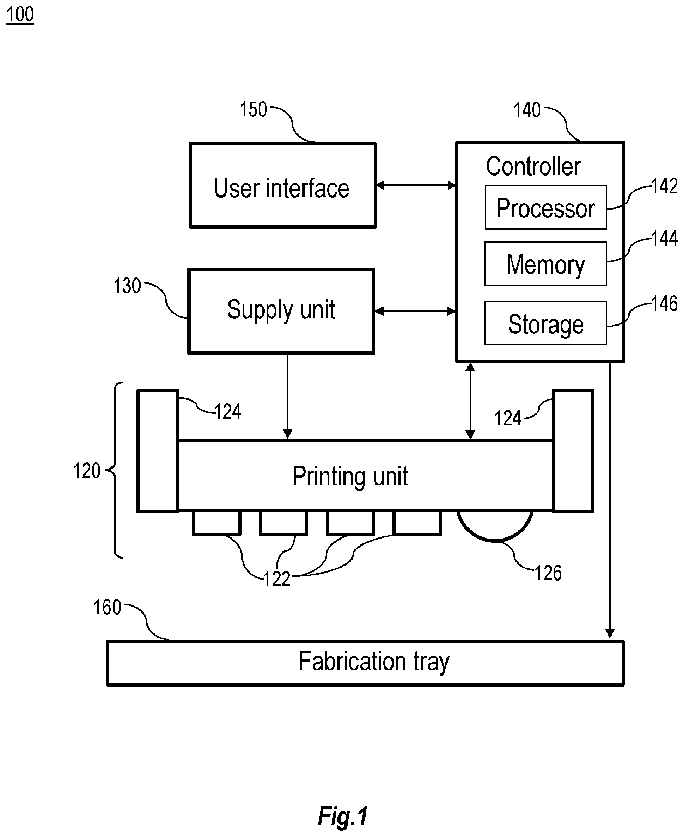

Reference is now made to **Fig. 1****,** which is a schematic illustration of a 3D printing system 100 for printing 3D objects, according to some embodiments of the invention.

According to some embodiments, 3D printing system **100** may include a printing unit **120,** a supply unit **130,** a controller **140,** a user interface **150** and a fabrication tray **160.** Controller **140** may be configured to control all elements of 3D printing system **100.**

According to some embodiments, printing unit **120** may include one or more print heads 122, one or more hardening subunits **124,** and one or more leveling subunits **126.** Print heads **122** may be adapted to deposit material using any ink-jet method. Printing unit **120** may move horizontally in both X and Y directions and optionally also vertically in the Z direction, above a square or rectangular fabrication tray **160.** In some other embodiments, printing unit **120** is moving radially above a circular fabrication tray **160.** In some further embodiments, some or all of the elements constituting printing unit **160** (e.g., leveling subunit **126,** hardening unit **124,** print heads **122**) are mounted at distinct locations of printing system **100** and can be either static or mobile. In some embodiments, the fabrication tray is static and in some other embodiments the fabrication tray is mobile, e.g. a rotary fabrication tray, or moving in the X, Y and/or Z directions.

Each print head **122** may deposit one or more materials, such that two or more materials may be deposited in a single deposition scan. Print head(s) **122** may be fed with the material(s) supplied by supply unit **130.** As known in the art, the term "print head" or "3D printing head" refers to a hardware component that is suitable to dispense 3D printing material(s) at a predefined position. Implementations of commercially available 3D printing heads may include a single channel (e.g., hold a single type or color of printing material) or a multiple channel (e.g., hold one or more types or colors of printing materials). In some embodiments, single print head of print heads **122** may be configured to deposit different materials (e.g., dual channel print head, multiple channel print head).

Hardening subunit(s) **124** may include any device that is adapted to emit light, heat and the like that may cause the printed material to harden. For example, hardening subunit(s) **124** may include one or more ultraviolet (UV) lamps (e.g., mercury lamp, UV LED assembly) for curing the deposited material.

Leveling subunit **126** may include any device that may be configured to level and/or control the thickness and/or flatness of the newly formed layer by sweeping over the layer and removing excess material. For example, leveling subunit **126** may be a roller. Leveling subunit **126** may include a waste collection device (not shown) for collecting the excess material generated during the leveling process.

Supply unit **130** may include one or more material containers or cartridges for supplying the material(s) to print head(s) **122.**

Controller **140** may include a processor **142,** a memory **144** and a storage **146.** Processor **142** may, for example, control the movement of printing unit **120** in a desired direction. Memory **144** may, for example, include an executable code. The executable code may include codes or instructions for controlling 3D printing system **100** to print 3D objects according to embodiments of the present invention. Storage **146** may store files that include design parameters of the 3D objects and the corresponding support structures to be printed by 3D printing system **100.**

User interface **150** may be or may include input devices such as a mouse, a keyboard, a touch screen or pad or any suitable input devices and output devices. User interface **50** may allow a user to upload or update codes and instructions for controlling printing of 3D objects according to some embodiments of the invention and/or to upload and update files comprising the design of the 3D objects (e.g., computer aided design (CAD) files) into storage **146.**

Fabrication tray **160** may be any tray, building or printing surface that is suitable to bear 3D objects and their corresponding support constructions as they are being printed, e.g., fabricated. Fabrication tray **160** may be attached, connected to or include an X-Y table and may be controlled, e.g., by controller **140,** to move in the Z direction and/or optionally in the X-Y plane according to the requirements of the printing process. In some other embodiments, fabrication tray **160** is a circular tray configured to rotate around a central axis and to optionally move in the Z direction.

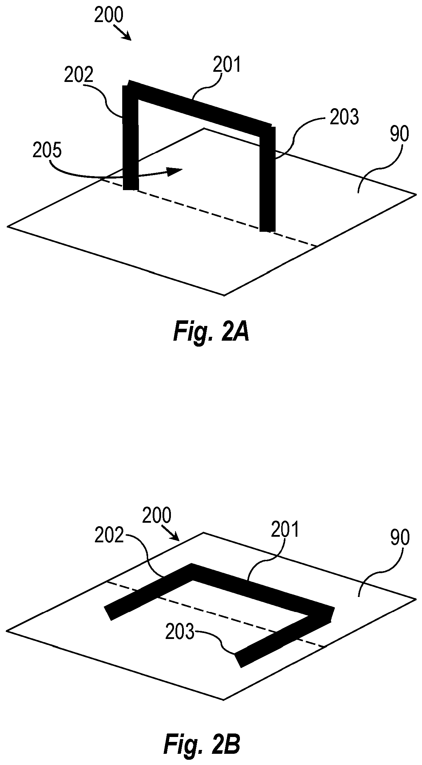

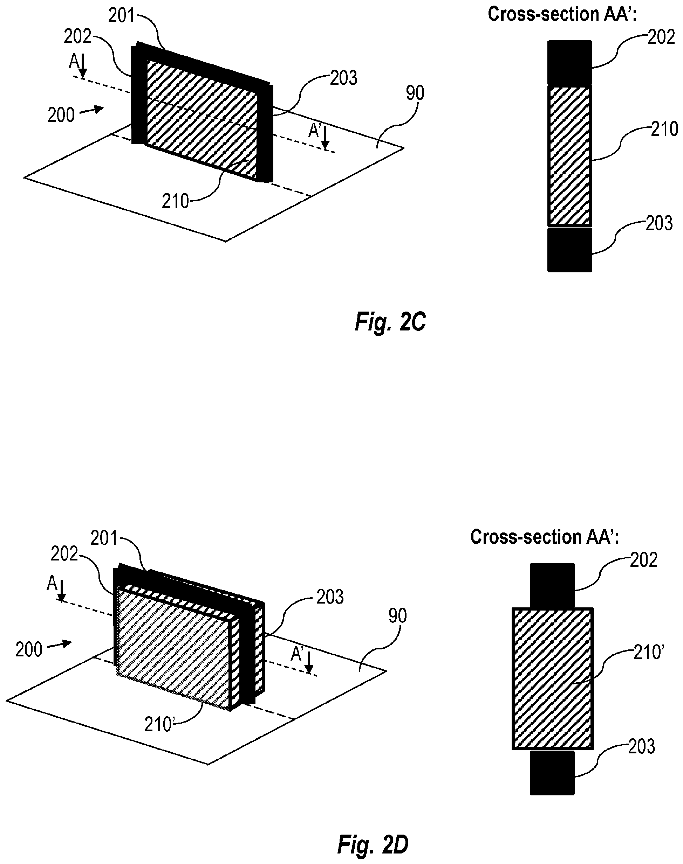

Reference is now made to **Figs. 2A, 2B****,** **2C** and **2D****,** which are schematic illustrations of various options of printing a 3D object **200** using a 3D printing system.

**Fig. 2A** depicts a 3D object **200** including a crossbar **201** supported at each end by bars **202, 203,** respectively, as an example of a 3D object printable by a 3D printing system (such as system **100** described above with respect to **Fig. 1**). 3D object **200** may include a gap **205** surrounded by crossbar **201** and bars **202, 203.**

Typically, 3D printing systems (such as 3D printing system **100**) print 3D objects (such as 3D object **200**) by depositing a building material and/or a support material, in layers, to form the 3D object and/or a support structure, respectively.

For example, 3D object **200** may be placed in its vertical position (as shown in **Fig. 2A**) or in its horizontal position, e.g., when laying on its side (as shown in **Fig. 2B**) on a fabrication tray **90** of the 3D printing system (e.g., such as fabrication tray **160** described above with respect to **Fig. 1**). In the example shown in **Fig. 2B****,** none or no substantial amount of support material is required to print 3D object **200.** However, 3D object **200** may occupy significantly more space on fabrication tray **90** when printed in a horizontal position as compared to being printed in a vertical position as shown in **Fig. 2A****.** This may be a disadvantage, especially when printing more than one 3D object during a single print cycle.

**Figs. 2C** and **2D** show 3D object **200** being printed in a vertical position on fabrication tray **90.** In order to print such a 3D object **200** in a vertical position, the 3D printing system deposits layer-by-layer a building material and a support material to form the 3D object 200 and a support structure **210** or **210',** as shown in **Fig. 2C** and **2D** respectively. The support structure is constructed to fill portions of the 3D object that are designed to be an empty space (such as gap **205** in 3D object **200**) in order to support portions of the 3D object to be printed subsequently, e.g., above the empty space (such as crossbar **201** in 3D object **200**)**.**

Typically, 3D printing systems print 3D objects based on 3D cross-sectional digital data including a set of horizontal slices each representing a respective horizontal cross-section of the 3D object. Each of the horizontal slices is typically generated on a standalone basis and directly uploaded to the printing systems for printing. The data from the slice may then be purged from a memory of the 3D printing system when the printing of the slice is completed. Thus, at a specific time t, the 3D printing system has generally only a partial information regarding the geometry of the whole 3D object.

Accordingly, 3D printing systems are typically configured to identify regions in at least some of the slices that are designed to be an empty space and deposit the support material into the regions thereof and thereby construct the support structure. In **Fig. 2C****,** dashed line AA' indicates a cross-section of the vertical 3D object to be built, by depositing at least a modeling material to form bars **202** and **203,** as well as at least a support material to form support construction **210** occupying gap **205** (shown in **Fig. 2A**) between bars **202, 203.** In such a manner, support structure **210** may be constructed to support the formation of crossbar **201,** by occupying the gap **205** immediately below crossbar **201** while it is being printed, e.g., within a region defined by a top projection of crossbar **201,** and then support structure **210** may be removed to reveal gap **205.**

However, support material typically has inferior mechanical properties as compared to the building material(s) used to construct the 3D object. Thus, the support structure constructed immediately below the portion of the 3D object to be supported and within the region defined by the top projection thereof, like support structure **210** shown in **Fig. 2C****,** may not be strong enough to support the portion, and as a result, may fail and cause termination of the printing.

Accordingly, 3D printing systems may, in some cases, construct a support structure **210'** that extends beyond the dimensions defined by the projection of the top, e.g., crossbar **201** portion, as shown for example in **Fig. 2D****.** For example, support structure **210'** may be wider (as shown for example in the cross-section (slice) AA' of **Fig. 2A**) and have stronger mechanical properties as compared to support structure **210.** However, support structure **210'** may include more support material and take up more space on the fabrication tray than support structure **210,** thus wasting material and space on fabrication tray **90.**

There is, therefore, a need for a system and method capable of predefining an improved support structure(s) for 3D object(s) for printing thereof using a 3D printing system. The improved support structures may be strong enough to support portions of the 3D object being printed and yet occupy less space and/or require less support material(s) than typical/default support structures (such as support structures **210, 210'** as described above with respect to **Figs. 2C** and **2D****,** respectively).

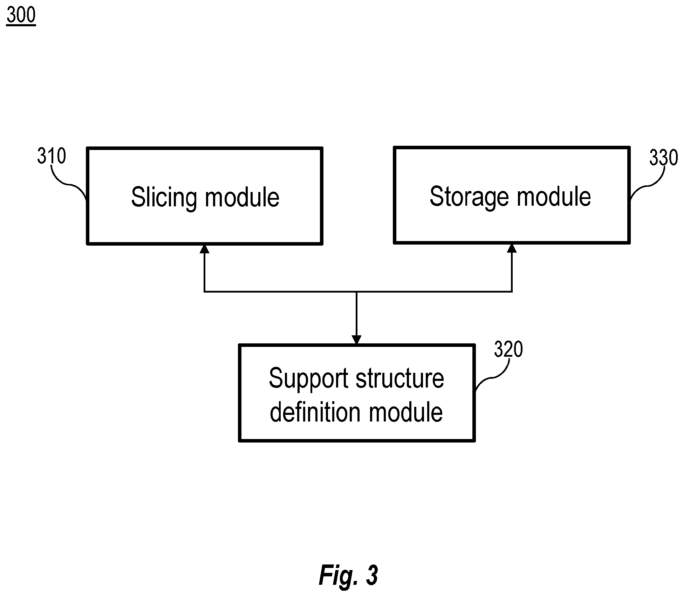

Reference is now made to **Fig. 3****,** which is a schematic block diagram of a system **300** for defining at least one support structure for at least one 3D object to be printed using a 3D printing system, according to some embodiments of the invention.

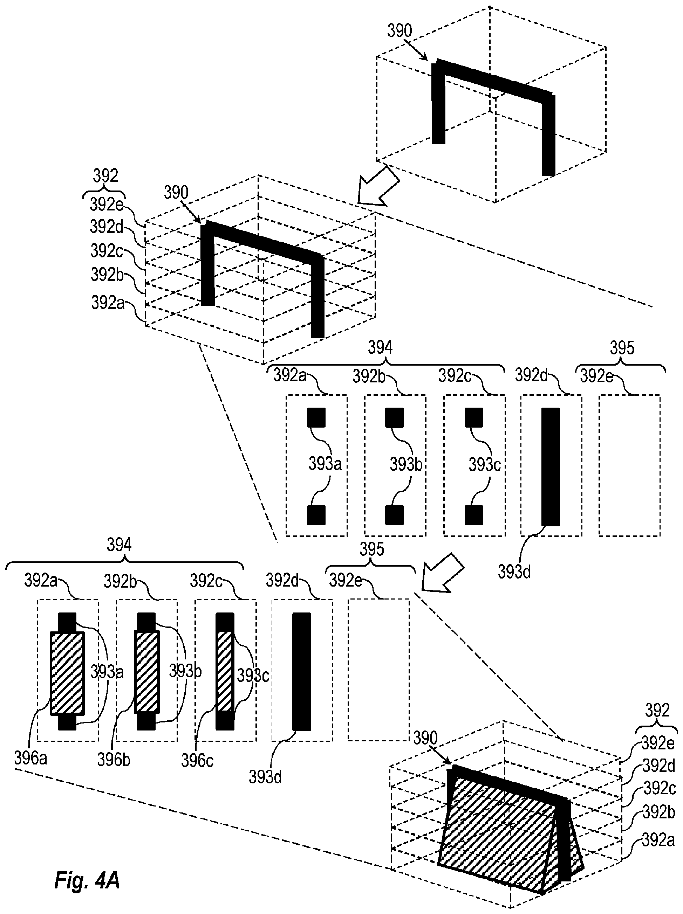

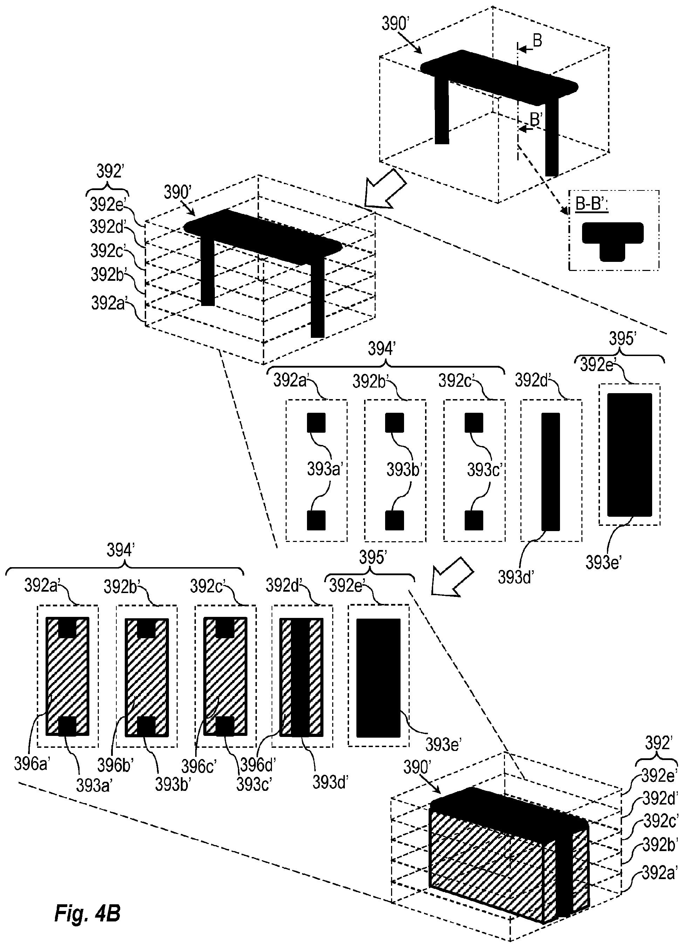

Reference is also made to **Fig. 4A** and **4B****,** which show different examples of predefining at least one support structure for at least one 3D object to be printed using a 3D printing system, according to some embodiments of the invention.

According to some embodiments, system **300** may include a slicing module **310,** a support structure definition module **320** and a storage module **330.** Slicing module **310,** support structure definition module **320** and storage module **330** may be in communication with each other (e.g., as shown in **Fig.** 3).

According to some embodiments, slicing module **310** may be configured to receive a 3D digital model of one or more 3D objects or an assembly of 3D object(s) or object parts to be printed using a 3D printing system. The 3D digital model may be provided as one or more files in, for example, STL, 3MF, OBJ or VRML format. The 3D printing system may be similar to, for example, 3D printing system **100** described above with respect to **Fig. 1****.**

Slicing module **310** may be configured to slice the 3D digital model to generate multiple slices, wherein each of at least some of the multiple slices includes at least one body region that represents a respective horizontal cross-section of the 3D object(s).

For example, **Fig. 4A** shows a 3D digital model **390** of a 3D object (such as 3D object **200** described above with respect to **Fig. 2A**). 3D digital model **390** may be sliced into multiple slices **392** (e.g., a first slice **392a,** a second slice **392b,** a third slice **392c,** a fourth slice **392d** and a fifth slice **392e**) as shown in **Fig. 4A****.** Some of slices **392** may have at least one body region **393** that represents a respective horizontal cross-section of the at least one 3D object. For example, first slice **392a** may include body regions **393a,** second slice **392b** may include body regions **393b,** third slice **392c** may include body regions **393c,** and/or fourth slice **392d** may include a body region **393d.** Fifth slice **392e** may, for example, not include body region(s) and support region(s) but only "no-print" regions, which are regions where printing materials are not deposited (e.g., as shown in **Fig.** 4A).

In some embodiments, slicing module **310** may be configured to deliver the generated multiple slices to storage module **330** which may be configured to store the multiple slices.

According to some embodiments, support structure definition module **320** may be configured to predefine one or more support structures for the 3D object(s), prior to actual printing of the 3D object(s) using the 3D printing system.

Support structure definition module **320** may be configured to analyze at least some of the multiple slices. Support structure definition module **320** may be configured to identify, based on the analysis thereof, at least one slice of the multiple slices that includes at least one body region (or at least a portion thereof) that has to be supported by at least one support structure when printing the at least one 3D object.

For example, fourth slice **392d** includes body region 393d, at least a portion of which has to be supported by one or more support structures when printing the 3D object(s) (e.g., as shown in **Fig. 3B**).

In some embodiments, support structure definition module **320** may be configured to select a subset of preceding slices of the multiple slices that precede the at least one identified slice, wherein each of the slices of the subset of preceding slices has to include at least one support region, to thereby form the support structure(s) needed to support the at least one body region (or the portion thereof) in the at least one identified slice.

For example, a subset **394** of preceding slices may include first slice **392a,** second slice **392b** and third slice **392c** that have to include at least one support region to form the support structure(s) under body region **393d** identified in fourth slice **392d.**

In some embodiments, support structure definition module **320** may be configured to select a subset of subsequent slices of the multiple slices that are subsequent to the at least one identified slice.

For example, a subset **395** of subsequent slices may include fifth slice **392e** that is subsequent to identified fourth slice **392d** (e.g., as shown in **Fig. 4A**).

In some embodiments, support structure definition module **320** may be configured to determine, based on a predetermined set of rules, whether an improved support structure may be defined at least for the body region(s) in the at least one identified slice.

The predetermined set of rules may, for example, include at least one of: a specified width threshold, a specified distance threshold (e.g., height from an underlying body region/tray), a specified length threshold and/or an absence of body region(s) in one of the subsequent slices that is wider than the body region(s) in the at least one identified slice.

For example, support structure definition module **320** may be configured to determine whether the body region(s) in the at least one identified slice meet the predetermined set of rules.

In this example, support structure definition module **320** may be configured to determine whether a width of the body region(s) in the at least one identified slice is smaller than the specified width threshold.

Yet, in this example, support structure definition module **320** may be configured to determine whether a distance between (i) the body region(s) in the at least one identified slice and (ii) body region(s) in one of the preceding slices immediately below the body region(s) in the at least one identified slice or (iii) a fabrication tray, is larger than the specified distance threshold.

Yet, in this example, support structure definition module **320** may be configured to determine whether a length of the body region(s) in the at least one identified slice is larger than the specified length threshold.

Yet, in this example, support structure definition module **320** may be configured to determine whether there are no body regions in the subsequent slices that are wider than the body region(s) in the identified slice.

In some embodiments, when the body region(s) in the at least one identified slice meet the predetermined set of rules (e.g., as described above), support structure definition module **320** may be configured to define one or more improved support structures for the body region(s) in the at least one identified slice.

In these embodiments, support structure definition module **320** may be configured to define, for each of the subset of preceding slices, at least one support region such that a width of the at least one support region in the subset of preceding slices may gradually increase between a last slice in the subset that is adjacent to the at least one identified slice and a first slice in the subset. In this manner, the improved support structure may, for example, have a triangular prism shape (e.g., as shown in **Fig. 4A****)**.

For example, a first support region **396a** may be defined for first slice **392a,** a second support region **396b** may be defined for second slice **392b,** and a third support region **396c** may be defined for third slice **392c** (e.g., as shown in **Fig. 3B**). Third support region **396c** in third slice **392c** (e.g., the last slice in subset 394) may, for example, have the same width as a portion of body region **393d** in fourth slice **392d** that needs to be supported. Third support region **396c** in third slice **392c** (e.g., the last slice in subset 394) may be narrower than, for example, second support region **396b** in second slice **392b** that may be narrower than, for example, first support region **396a** in first slice **392a** (e.g., the first slice of subset 394), e.g., as shown in **Fig. 4A****.**

In other embodiments, when the body region(s) in the at least one identified slice do not meet the predetermined set of rules, support structure definition module **320** may be configured to define a default support structure (e.g., such as support structure **210** described above with respect to **Fig. 2C**).

For example, if the width of the body region(s) in the at least one identified slice is larger than the specified width threshold, the default support structure (such as support structure **210** described above with respect to **Fig. 2C**) may be strong enough, and thus no improved support structure is required.

In another example, one of the slices that are subsequent to the at least one identified slice may include one or more body region(s) that is wider than the body region(s) in the at least one identified slice. In this case, the support structure for the wider body region in the subsequent slice may apparently include the support for the body region(s) of the at least one identified slice and thus no improved support structure is required.

For example, **Fig. 4B** shows a 3D digital model **390'** of 3D object in which its fifth slice **392e'** includes body region **393e'** that is wider than body region **393d'** in its fourth slice **392d'.** In this case, support regions **396a', 396b', 396c', 396d'** of slices **392a', 392b', 392c', 392d',** respectively, may have substantially the same width as body region **393e'** of fifth slice **392e'** and thus may apparently include support regions **396a, 396b, 396c** (e.g., improved support regions) described above with respect to **Fig. 4A****.** Thus, no improved support structure is required.

In some embodiments, support structure definition module **320** may be configured to determine that the support region(s) defined for a particular 3D object do not inhibit the construction of other 3D objects (e.g., adjacent objects) on the fabrication tray. In the case of a detected inhibition, support structure definition module **320** may be configured to modify the location of the 3D objects on the fabrication tray based on the multiple slices to avoid the inhibition of their construction.

According to some embodiments, slicing module **310** may be configured to slice the 3D digital model to thereby generate a 3D digital dataset including the multiple slices and having a 3D digital dataset resolution that is coarser than a predetermined resolution of the 3D printing system.

The 3D digital dataset may be then used for predefining the support structure(s) for the 3D model (e.g., as described above with respect to **Figs. 3****,** **4A** and **4B**). It has been found that defining the supporting structure(s) using the 3D digital dataset resolution that is smaller than the printing resolution of the 3D printing system enables getting a faster definition of the support structure(s).

In various embodiments, the 3D digital dataset resolution used for generating the 3D digital dataset with slicing module **310** may be selected based on a number and/or a complexity of the 3D object(s) and a desired time (e.g., defined by a user) required for support structure(s) to be defined.

According to various embodiments, each of slicing module **310,** support structure definition module **320** and/or storage module **330** may be implemented on its own computing device, a single (e.g., shared) computing device, or a combination of computing devices. In various embodiments, the communication between slicing module **310,** support structure definition module **320** and/or storage module 330 may be wired or wireless.

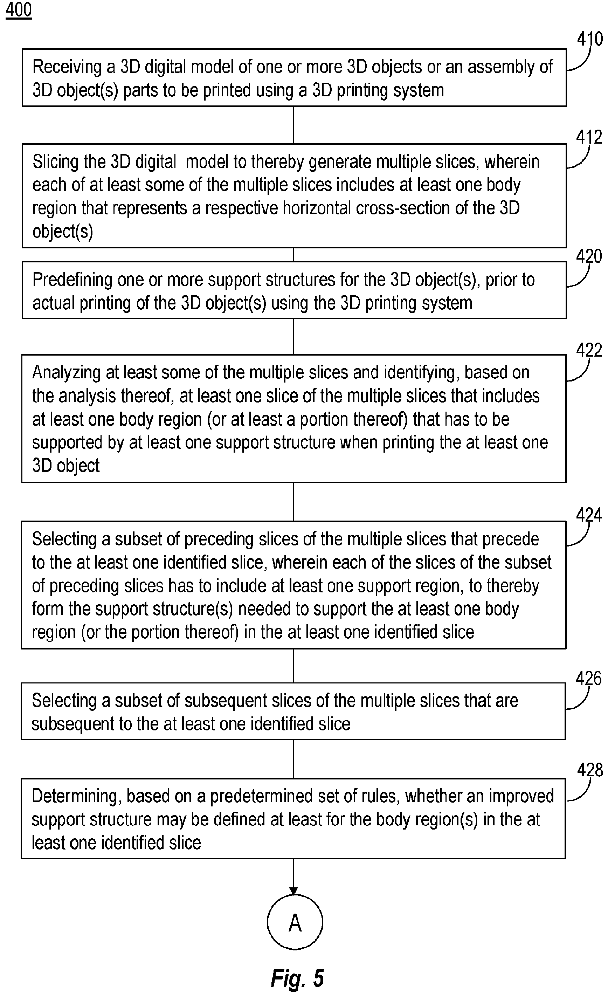

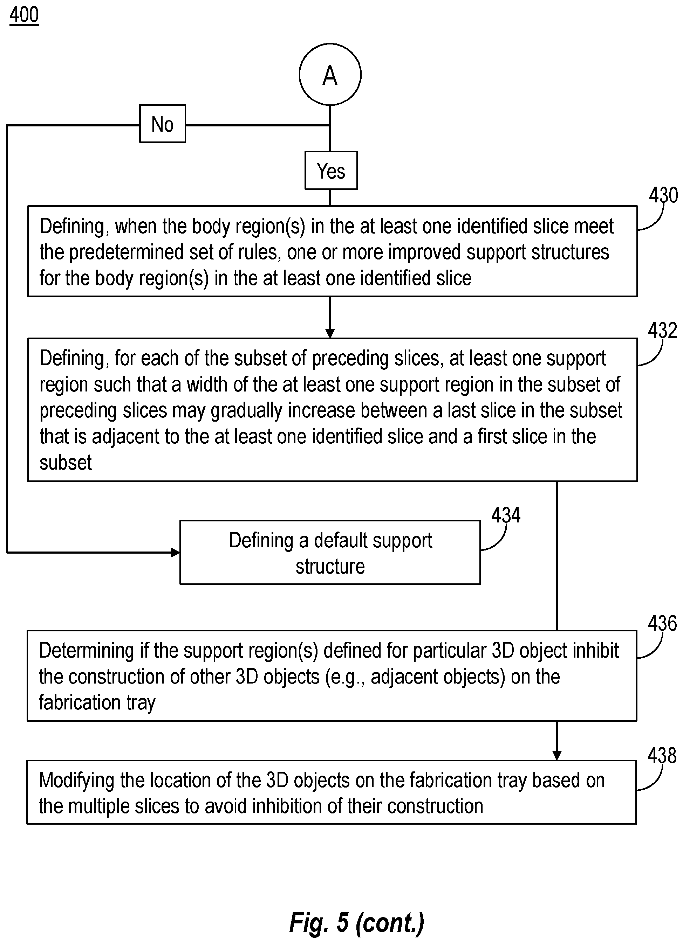

Reference is made to **Fig. 5****,** which is a flowchart of a method **400** of predefining at least one support structure for at least one 3D object to be printed using a 3D printing system, according to some embodiments of the invention.

Method **400** may be implemented by a system for predefining at least one support structure for at least one 3D object for printing thereof using a 3D printing system (such as system **300** described above with respect to **Figs. 3****,** **4A** and **4B**), which may be configured to implement method **400.**

According to some embodiments, method **400** may include receiving a 3D digital model of one or more 3D objects or an assembly of 3D object(s) parts to be printed using a 3D printing system (stage 410). For example, the 3D model may be similar to 3D model **390** described above with respect to **Fig. 4A****.**

In some embodiments, method **400** may include slicing the 3D digital model to thereby generate multiple slices, wherein each of at least some of the multiple slices includes at least one body region that represents a respective horizontal cross-section of the 3D object(s) (stage **412**). For example, the slicing of the 3D digital model into the multiple slices may be performed by slicing module **310** of system **300** as describe above with respect to **Figs. 3****,** **4A** and **4B****.**

According to some embodiments, method **400** may include predefining one or more support structures for the 3D object(s), prior to actual printing of the 3D object(s) using the 3D printing system (stage **420).** For example, the predefining one or support structures may be performed by support structure definition module **320** of system **300** as described above with respect to **Figs. 3****,** **4A** and **4B****.**

In some embodiments, method **400** may include analyzing at least some of the multiple slices and identifying, based on the analysis thereof, at least one slice of the multiple slices that includes at least one body region (or at least a portion thereof) that has to be supported by at least one support structure when printing the at least one 3D object (stage **422**) (e.g., as described above with respect to **Figs. 3****,** **4A** and **4B**).

In some embodiments, method **400** may include selecting a subset of preceding slices of the multiple slices that precede the at least one identified slice, wherein each of the slices of the subset of preceding slices has to include at least one support region, to thereby form the support structure(s) needed to support the at least one body region (or the portion thereof) in the at least one identified slice (stage **424**) (e.g., as described above with respect to **Figs. 3****,** **4A** and **4B**).

In some embodiments, method **400** may include selecting a subset of subsequent slices of the multiple slices that are subsequent to the at least one identified slice (stage **426**) (e.g., as described above with respect to **Figs. 3****,** **4A** and **4B**).

In some embodiments, method **400** may include determining, based on a predetermined set of rules, whether an improved support structure may be defined at least for the body region(s) in the at least one identified slice (stage **428**) (e.g., as described above with respect to **Figs. 3****,** **4A** and **4B**).

The predetermined set of rules may, for example, include at least one of: a specified width threshold, a specified distance threshold, a specified length threshold and/or an absence of building region(s) in one of the subsequent slices that is wider than the body region(s) in the at least one identified slice (e.g., as described above with respect to **Figs. 3****,** **4A** and **4B**).

In some embodiments, method **400** may include determining that a width of the at least one body region in the at least one identified slice is smaller than a specified width threshold to thereby determine that the at least one body region in the at least one identified slice meets the predetermined set of rules.

In some embodiments, method **400** may include determining that a distance between the at least one body region in the at least one identified slice and at least one body region in one of preceding slices immediately below the at least one body region in the at least one identified slice or a fabrication tray, is larger than a specified distance threshold to thereby determine that the at least one body region in the at least one identified slice meets the predetermined set of rules.

In some embodiments, method **400** may include determining that a length of the at least one body region in the at least one identified slice is larger than the specified length threshold to thereby determine that the at least one body region in the at least one identified slice meets the predetermined set of rules.

In some embodiments, method **400** may include determining that there are no body regions in at least one of slices that are subsequent to the at least one identified slice that are wider than the at least one body region in the at least one identified slice to thereby determine that the at least body region in the at least one identified slice meets the set of predetermined rules.

In some embodiments, method **400** may include defining, when the body region(s) in the at least one identified slice meet the predetermined set of rules, one or more improved support structures for the body region(s) in the at least one identified slice (stage **430**).

In these embodiments, method **400** may include defining, for each of the subset of preceding slices, at least one support region such that a width of the at least one support region in the subset of preceding slices may gradually increases between a last slice in the subset that is adjacent to the at least one identified slice and a first slice in the subset (stage **432**) (e.g., as described above with respect to **Figs. 3****,** **4A** and **4B**).

In some other embodiments, when the body region(s) in the at least one identified slice do not meet the predetermined set of rules, method **400** may include defining a default support structure (stage **434**) (e.g., as described above with respect to **Figs. 3****,** **4A** and **4B**).

In some embodiments, method **400** may include determining if the support region(s) defined for a particular 3D object inhibit the construction of other 3D objects (e.g., adjacent objects) on the fabrication tray (stage **436**) (e.g., as described above with respect to **Figs. 3****,** **4A** and **4B**).

In some embodiments, method **400** may include modifying the location of the 3D objects on the fabrication tray based on the multiple slices to avoid inhibition of their construction (stage **438**) (e.g., as described above with respect to **Figs. 3****,** **4A** and **4B**).

Advantageously, the disclosed system and method may enable to predefine an improved support structure(s) for 3D object(s) for printing thereof using a 3D printing system. The improved support structures may be strong enough to support portions of the 3D object being printed and yet occupy less space and/or require less support material than typical/default support structures, thus overcoming the disadvantages of the typical/default support structures currently used in 3D printing (e.g., as described above with respect to **Figs. 3****,** **4A****,** **4B** and **5**).

Aspects of the present invention are described above with reference to flowchart illustrations and/or portion diagrams of methods, apparatus (systems) and computer program products according to embodiments of the invention. It will be understood that each portion of the flowchart illustrations and/or portion diagrams, and combinations of portions in the flowchart illustrations and/or portion diagrams, can be implemented by computer program instructions. These computer program instructions can be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or portion diagram or portions thereof.

These computer program instructions can also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or portion diagram portion or portions thereof. The computer program instructions can also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or portion diagram portion or portions thereof.

The aforementioned flowchart and diagrams illustrate the architecture, functionality, and operation of possible implementations of systems, methods and computer program products according to various embodiments of the present invention. In this regard, each portion in the flowchart or portion diagrams can represent a module, segment, or portion of code, which includes one or more executable instructions for implementing the specified logical function(s). It should also be noted that, in some alternative implementations, the functions noted in the portion can occur out of the order noted in the figures. For example, two portions shown in succession can, in fact, be executed substantially concurrently, or the portions can sometimes be executed in the reverse order, depending upon the functionality involved. It will also be noted that each portion of the portion diagrams and/or flowchart illustration, and combinations of portions in the portion diagrams and/or flowchart illustration, can be implemented by special purpose hardware-based systems that perform the specified functions or acts, or combinations of special purpose hardware and computer instructions.

In the above description, an embodiment is an example or implementation of the invention. The various appearances of "one embodiment", "an embodiment", "certain embodiments" or "some embodiments" do not necessarily all refer to the same embodiments. Although various features of the invention can be described in the context of a single embodiment, the features can also be provided separately or in any suitable combination. Conversely, although the invention can be described herein in the context of separate embodiments for clarity, the invention can also be implemented in a single embodiment. Certain embodiments of the invention can include features from different embodiments disclosed above, and certain embodiments can incorporate elements from other embodiments disclosed above. The disclosure of elements of the invention in the context of a specific embodiment is not to be taken as limiting their use in the specific embodiment alone. Furthermore, it is to be understood that the invention can be carried out or practiced in various ways and that the invention can be implemented in certain embodiments other than the ones outlined in the description above.

The invention is not limited to those diagrams or to the corresponding descriptions. For example, flow need not move through each illustrated box or state, or in exactly the same order as illustrated and described. Meanings of technical and scientific terms used herein are to be commonly understood as by one of ordinary skill in the art to which the invention belongs, unless otherwise defined. While the invention has been described with respect to a limited number of embodiments, these should not be construed as limitations on the scope of the invention, but rather as exemplifications of some of the preferred embodiments. Other possible variations, modifications, and applications are also within the scope of the invention. Accordingly, the scope of the invention should not be limited by what has thus far been described, but by the appended claims and their legal equivalents.

## Claims

1. A computer implemented method of defining at least one support structure for at least one 3D object to be printed using a 3D printing system, the method comprising:
receiving a 3D digital model of at least one 3D object to be printed;
slicing the 3D digital model to generate a 3D digital dataset comprising multiple slices, wherein each of at least some of the multiple slices includes at least one body region that represents a respective horizontal cross-section of the at least one 3D object;
identifying at least one slice of the multiple slices that includes at least one body region that has to be supported by at least one support structure when printing the at least one 3D object;
determining whether the at least one body region in the at least one identified slice meets a predetermined set of rules;
if the at least one body region in the at least one identified slice does not meet the predetermined set of rules, defining at least one default support structure for the at least one body region in the at least one identified slice; and
if the at least one body region in the at least one identified slice meets the predetermined set of rules, defining at least one improved support structure for the at least one body region in the at least one identified slice,
wherein the at least one default support structure and the at least one improved support structure are defined using a resolution of the 3D digital dataset that is coarser than a printing resolution of the 3D printing system,
wherein the at least one improved support structure is defined such that it occupies less space on a fabrication tray of the 3D printing system than the at least one default support structure and/or requires less supporting material than the at least one default support structure,
wherein defining the at least one improved support structure comprises:
selecting a subset of preceding slices of the multiple slices that precede the at least one identified slice, wherein each of the slices of the subset of preceding slices has to include at least one support region to be filled with a supporting material when printing the at least one 3D object, to thereby form the at least one support structure needed to support the at least one body region in the at least one identified slice; and
defining at least one support region for each slice of the subset of preceding slices such that a width of the at least one support region in the subset of preceding slices gradually increases between a last slice in the subset that is adjacent to the at least one identified slice and a first slice in the subset.

2. The method of claim 1, wherein determining that the at least one body region in the at least one identified slice meets the predetermined set of rules comprises:
determining that a width of the at least one body region in the at least one identified slice is smaller than a specified width threshold.

3. The method of any one of claims 1-2, wherein determining that the at least one body region in the at least one identified slice meets the predetermined set of rules comprises:
determining that a distance between the at least one body region in the at least one identified slice and at least one body region in one of preceding slices immediately below the at least one body region in the at least one identified slice or the fabrication tray is larger than a specified distance threshold.

4. The method of any one of claims 1-3, wherein determining that the at least one body region in the at least one identified slice meets the predetermined set of rules comprises:
determining that a length of the at least one body region in the at least one identified slice is larger than a specified length threshold.

5. The method of any one of claims 1-4, wherein determining that the at least one body region in the at least one identified slice meets the predetermined set of rules comprises:
determining that there are no body regions in at least one slices that are subsequent to the at least one identified slice that is wider than the at least one body region in the at least one identified slice.

6. The method of any one of claims 1-5, comprising:
determining if the at least one improved support structure defined for the at least one 3D object obstruct the construction of at least one other 3D object on the fabrication tray; and
if so, modifying a location of one or more of the at least one 3D object and the at least one another 3D object on the fabrication tray to avoid the obstruction thereof.

7. A system for defining at least one support structure for at least one 3D object to be printed using a 3D printing system, the system comprising:
a slicing module configured to:
receive a 3D digital model of at least one 3D object to be printed; and
slice the 3D digital model to generate a 3D digital dataset comprising multiple slices, wherein each of at least some of the multiple slices includes at least one body region that represents a respective horizontal cross-section of the at least one 3D object; and
a support structure definition module configured to:
identify at least one slice of the multiple slices that includes at least one body region that has to be supported by at least one support structure when printing the at least one 3D object;
determine whether the at least one body region in the at least one identified slice meets a predetermined set of rules;
if the at least one body region in the at least one identified slice does not meet a predetermined set of rules, define at least one default support structure for the at least one body region in the at least one identified slice; and
if the at least one body region in the at least one identified slice meets the predetermined set of rules, define at least one improved support structure for the at least one body region in the at least one identified slice,
wherein the at least one default support structure and the at least one improved support structure are defined using a resolution of the 3D digital dataset that is coarser than a printing resolution of the 3D printing system,
wherein the at least one improved support structure is defined such that it occupies less space on a fabrication tray of the 3D printing system than the at least one default support structure and/or requires less supporting material than the at least one default support structure,
wherein in order to define the at least one improved support structure, the support structure definition module is configured to:
select a subset of preceding slices of the multiple slices that precede the at least one identified slice, wherein each of the slices of the subset of preceding slices has to include at least one support region to be filled with a supporting material when printing the at least one 3D object, to thereby form the at least one support structure needed to support the at least one body region in the at least one identified slice; and
define at least one support region for each slice of the subset of preceding slices such that a width of the at least one support region in the subset of preceding slices gradually increases between a last slice in the subset that is adjacent to the at least one identified slice and a first slice in the subset.

8. The system of claim 7, wherein in order to determine that the at least one body region in the at least one identified slice meets the predetermined set of rules, the support structure definition module is configured to:
determine that a width of the at least one body region in the at least one identified slice is smaller than a specified width threshold.

9. The system of any one of claims 7-8, wherein in order to determine that the at least one body region in the at least one identified slice meets the predetermined set of rules, the support structure definition module is configured to:
determine that a distance between the at least one body region in the at least one identified slice and at least one body region in one of preceding slices immediately below the at least one body region in the at least one identified slice or the fabrication tray is larger than a specified distance threshold.

10. The system of any one of claims 7-9, wherein in order to determine that the at least one body region in the at least one identified slice meets the predetermined set of rules, the support structure definition module is configured to:
determine that a length of the at least one body region in the at least one identified slice is larger than a specified length threshold.

11. The system of any one of claims 7-10, wherein in order to determine that the at least one body region in the at least one identified slice meets the predetermined set of rules, the support structure definition module is configured to:
determine that there are no body regions in at least one of slices that are subsequent to the at least one identified slice that are wider than the at least one body region in the at least one identified slice.

12. The system of any one of claims 7-11, wherein the slicing module is configured to:
determine whether the at least one improved support structure defined for the at least one 3D object obstructs the construction of at least one other 3D object on the fabrication tray; and
if so, modify a location of one or more of the at least one 3D object and the at least one another 3D object on the fabrication tray to avoid the obstruction thereof.

## Patentansprüche

1. Computerimplementiertes Verfahren zum Definieren mindestens einer Stützstruktur für mindestens ein zu druckendes 3D-Objekt, wobei ein 3D-Drucksystem verwendet wird, umfassend wie folgt:
Empfangen eines 3D-digitalen Modells mindestens eines zu druckenden 3D-Objekts;
Slicing des 3D-digitalen Modells, um einen 3D-digitalen Datensatz zu erzeugen, der jeweils eine Mehrzahl von Schichten umfasst, wobei jede der mindestens manchen der Mehrzahl der Schichten jeweils mindestens eine Körperregion aufweist, die jeweils einen jeweiligen horizontalen Querschnitt des mindestens einen 3D-Objekts repräsentiert;
Identifizieren mindestens einer Schicht der Mehrzahl von Schichten, die mindestens eine Körperregion aufweist, die von mindestens einer Stützstruktur unterstützt werden muss, wenn das mindestens eine 3D-Objekt gedruckt wird;
Bestimmen, ob die mindestens eine Körperregion in der mindestens einen identifizierten Schicht einen vorbestimmten Regelsatz erfüllt;
falls die mindestens eine Körperregion in der mindestens einen identifizierten Schicht den vorbestimmten Regelsatz nicht erfüllt, Definieren mindestens einer standardgemäßen Stützstruktur für die mindestens eine Körperregion in der mindestens einen identifizierten Schicht; und
falls die mindestens eine Körperregion in der mindestens einen identifizierten Schicht den vorbestimmten Regelsatz erfüllt, Definieren mindestens einer verbesserten Stützstruktur für die mindestens eine Körperregion in der mindestens einen identifizierten Schicht,
wobei die mindestens eine standardgemäße Stützstruktur und die mindestens eine verbesserte Stützstruktur jeweils durch Verwenden einer Auflösung des 3D-digitalen Datensatzes definiert sind, die gröber ist als eine Druckauflösung des 3D-Drucksystems,
wobei die mindestens eine verbesserte Stützstruktur derart definiert ist, dass sie weniger Platz auf einer Fabrikationsunterlage des 3D-Drucksystems einnimmt als die mindestens eine standardgemäße Stützstruktur und/oder dass sie weniger Stützmaterial erfordert als die mindestens eine standardgemäße Stützstruktur,
wobei Definieren der mindestens einen verbesserten Stützstruktur wie folgt umfasst:
Auswählen einer Untermenge von vorhergehenden Schichten aus der Mehrzahl der Schichten, die der mindestens einen identifizierten Schicht vorhergehen, wobei jede der Schichten der Untermenge der vorhergehenden Schichten mindestens eine Stützregion aufweisen muss, die mit einem Stützmaterial zu befüllen ist, wenn mindestens ein 3D-Objekt gedruckt wird, um dadurch mindestens eine Stützstruktur zu bilden, die gebraucht wird, um die mindestens eine Körperregion in der mindestens einen identifizierten Schicht abzustützen; und
Definieren mindestens einer Stützregion für jede Schicht der Untermenge von vorhergehenden Schichten, derart, dass eine Breite der mindestens einen Stützregion in der Untermenge von vorhergehenden Schichten zwischen einer jeweils letzten Schicht der Untermenge, die benachbart zu der jeweils mindestens einen identifizierten Schicht ist, und einer ersten Schicht in der Untermenge jeweils graduell zunimmt.

2. Verfahren nach Anspruch 1, wobei Bestimmen, dass die mindestens eine Körperregion in der mindestens einen identifizierten Schicht jeweils den vorbestimmten Regelssatz erfüllt, wie folgt umfasst:
Bestimmen, dass eine Breite der mindestens einen Körperregion in der mindestens einen identifizierten Schicht kleiner ist als ein festgelegter Breiten-Schwellenwert.

3. Verfahren nach einem der Ansprüche 1-2, wobei Bestimmen, dass die mindestens eine Körperregion in der mindestens einen identifizierten Schicht jeweils den vorbestimmten Regelssatz erfüllt, wie folgt umfasst:
Bestimmen, dass eine Entfernung zwischen der mindestens einen Körperregion in der mindestens einen identifizierten Schicht und mindestens eine Körperregion in einer der vorhergehenden Schichten unmittelbar unterhalb der mindestens einen Körperregion in der mindestens einen identifizierten Schicht oder der Fabrikationsunterlage größer ist als ein festgelegter Entfernungs-Schwellenwert.

4. Verfahren nach einem der Ansprüche 1-3, wobei Bestimmen, dass die mindestens eine Körperregion in der mindestens einen identifizierten Schicht jeweils den vorbestimmten Regelssatz erfüllt, wie folgt umfasst:
Bestimmen, dass eine Länge der mindestens einen Körperregion in der mindestens einen identifizierten Schicht jeweils größer ist als ein festgelegter Längen-Schwellenwert.

5. Verfahren nach einem der Ansprüche 1-4, wobei Bestimmen, dass die mindestens eine Körperregion in der mindestens einen identifizierten Schicht jeweils den vorbestimmten Regelssatz erfüllt, wie folgt umfasst:
Bestimmen, dass es keine Körperregionen in mindestens einer der Schichten gibt, die auf die mindestens eine identifizierte Schicht folgen, die breiter sind als die mindestens eine Körperregion in der mindestens einen identifizierten Schicht.

6. Verfahren nach einem der Ansprüche 1-5 umfassend wie folgt:
Bestimmen, ob die mindestens eine verbesserte Stützstruktur, die für das mindestens eine 3D-Objekt definiert ist, die Konstruktion mindestens eines anderen 3D-Objekts auf der Fabrikationsunterlage behindert; und
falls dem so ist, Modifizieren eines Ortes von einem oder von mehr als einem 3D-Objekt und des mindestens einen weiteren 3D-Objekts auf der Fabrikationsunterlage, um die Behinderung desselben zu vermeiden.

7. System zum Definieren mindestens einer Stützstruktur für mindestens ein durch Verwenden eines 3D-Drucksystems zu druckenden 3D-Objekts, wobei das System wie folgt umfasst:
ein Slicing-Modul, das wie folgt konfiguriert ist zum:
Empfangen eines 3D-digitalen Modells mindestens eines zu druckenden 3D-Objekts; und zum
Slicing des 3D-digitalen Modells, um einen 3D-Datensatz zu erzeugen, der eine Mehrzahl von Schichten umfasst, wobei jede der mindestens manchen der Mehrzahl der Schichten jeweils mindestens eine Körperregion umfasst, die einen jeweiligen horizontalen Querschnitt des mindestens einen 3D-Objekts repräsentiert; und
ein Stützstruktur-Definitionsmodul, das konfiguriert ist wie folgt zum:
Identifizieren mindestens einer Schicht der Mehrzahl von Schichten, die mindestens eine Körperregion aufweisen, die von mindestens einer Stützstruktur unterstützt werden muss, wenn das mindestens eine 3D-Objekt gedruckt wird;
Bestimmen ob die mindestens eine Körperregion in der mindestens einen identifizierten Schicht nicht einen vorbestimmten Regelsatz erfüllt;
falls die mindestens eine Körperregion in der mindestens einen identifizierten Schicht den vorbestimmten Regelsatz nicht erfüllt, Definieren mindestens einer standardgemäßen Stützstruktur für die mindestens eine Körperregion in der mindestens einen identifizierten Schicht; und
falls die mindestens eine Körperregion in der mindestens einen identifizierten Schicht den vorbestimmten Regelsatz erfüllt, Definieren mindestens einer verbesserten Stützstruktur für die mindestens eine Körperregion in der mindestens einen identifizierten Schicht,
wobei die mindestens eine standardgemäße Stützstruktur und die mindestens eine verbesserte Stützstruktur jeweils durch Verwenden einer Auflösung des 3D-digitalen Datensatzes definiert sind, die gröber ist als eine Druckauflösung des 3D-Drucksystems,
wobei die mindestens eine verbesserte Stützstruktur derart definiert ist, dass sie weniger Platz auf einer Fabrikationsunterlage des 3D-Drucksystems einnimmt als die mindestens eine standardgemäße Stützstruktur und/der dass sie weniger Stützmaterial erfordert als die mindestens eine standardgemäße Stützstruktur,
wobei das Stützstruktur-Definitionsmodul zum Definieren der mindestens einen verbesserten Stützstruktur wie folgt konfiguriert ist zum:
Auswählen einer Untermenge von vorhergehenden Schichten aus der Mehrzahl der Schichten, die der mindestens einen identifizierten Schicht vorhergehen, wobei jede der Schichten der Untermenge der vorhergehenden Schichten mindestens eine Stützregion aufweisen muss, die mit einem Stützmaterial zu befüllen ist, wenn das mindestens eine 3D-Objekt gedruckt wird, um dadurch mindestens eine Stützstruktur zu bilden, die gebraucht wird, um die mindestens eine Körperregion in der mindestens einen identifizierten Schicht abzustützen; und
Definieren mindestens einer Stützregion für jede Schicht der Untermenge von vorhergehenden Schichten, derart, dass eine Breite der mindestens einen Stützregion in der Untermenge von vorhergehenden Schichten zwischen einer jeweils letzten Schicht der Untermenge, die benachbart zu der jeweils mindestens einen identifizierten Schicht ist, und einer ersten Schicht in der Untermenge jeweils graduell zunimmt.

8. System nach Anspruch 7, wobei gilt, um zu bestimmen, dass die mindestens eine Körperregion in der mindestens einen identifizierten Schicht den vorbestimmten Regelsatz erfüllt, das Stützstruktur-Definitionsmodul wie folgt konfiguriert ist zum:
Bestimmen, dass eine Breite der mindestens einen Körperregion in der mindestens einen identifizierten Schicht kleiner ist als ein festgelegter Breiten-Schwellenwert.

9. System nach einem der Ansprüche 7-8, wobei gilt, um zu bestimmen, dass die mindestens eine Körperregion in der mindestens einen identifizierten Schicht den vorbestimmten Regelsatz erfüllt, das Stützstruktur-Definitionsmodul wie folgt konfiguriert ist zum:
Bestimmen, dass eine Entfernung zwischen mindestens einer Körperregion in der mindestens einen identifizierten Schicht und mindestens eine Körperregion in einer von vorhergehenden Schichten unmittelbar unterhalb der mindestens einen Körperregion in der mindestens einen identifizierten Schicht oder der Fabrikationsunterlage größer ist als ein festgelegter Entfernungs-Schwellenwert.

10. System nach einem der Ansprüche 7-9, wobei gilt, um zu bestimmen, dass die mindestens eine Körperregion in der mindestens einen identifizierten Schicht den vorbestimmten Regelsatz erfüllt, das Stützstruktur-Definitionsmodul wie folgt konfiguriert ist zum:
Bestimmen, dass eine Länge der mindestens einen Körperregion in der mindestens einen identifizierten Schicht größer ist als ein festgelegter Längen-Schwellenwert.

11. System nach einem der Ansprüche 7-10, wobei gilt, um zu bestimmen, dass die mindestens eine Körperregion in der mindestens einen identifizierten Schicht den vorbestimmten Regelsatz erfüllt, das Stützstruktur-Definitionsmodul wie folgt konfiguriert ist zum:
Bestimmen, dass es keine Körperregionen in mindestens einer der Schichten gibt, die auf die mindestens eine identifizierte Schicht folgen, die breiter sind als die mindestens eine Körperregion in der mindestens einen identifizierten Schicht.

12. System nach einem der Ansprüche 7-11, wobei das Slicing-Modul wie folgt konfiguriert ist zum:
Bestimmen ob die mindestens eine verbesserte Stützstruktur, die für das mindestens eine 3D-Objektre definiert ist, die Konstruktion mindestens eines anderen 3D-Objekts auf der Fabrikationsunterlage behindert; und,
falls dem so ist, Modifizieren eines Ortes von einem oder von mehr als einem 3D-Objekt und des mindestens einen 3D-Objekts auf der Fabrikationsunterlage, um die Behinderung desselben zu vermeiden.

## Revendications

1. Procédé mis en œuvre par ordinateur pour la définition d'un moins une structure de soutien pour au moins un objet 3D à imprimer à l'aide d'un système d'impression 3D, le procédé comprenant les étapes consistant à :
recevoir un modèle numérique 3D d'au moins un objet 3D à imprimer ;
découper le modèle numérique 3D pour générer un ensemble de données numériques 3D comprenant plusieurs tranches, dans lequel chacune d'au moins quelques-unes des tranches multiples comprend au moins une région de corps qui représente une section transversale horizontale respective du ou des objets 3D ;
identifier au moins une tranche des tranches multiples qui comprend au moins une région de corps qui doit être soutenue par au moins une structure de soutien lors de l'impression du ou des objets 3D ;
déterminer si la ou les régions de corps dans la ou les tranches identifiées répondent à un ensemble prédéfini de règles ;
si la ou les régions de corps dans la ou les tranches identifiées ne répondent pas à l'ensemble prédéfini de règles, définir au moins une structure de soutien par défaut pour la ou les régions de corps dans la ou les tranches identifiées ;
si la ou les régions de corps dans la ou les tranches identifiées répondent à l'ensemble prédéfini de règles, définir au moins une structure de soutien améliorée pour la ou les régions de corps dans la ou les tranches identifiées,
dans lequel la ou les structures de soutien par défaut et la ou les structures de soutien améliorées sont définies en utilisant une résolution de l'ensemble de données numériques 3D qui est plus grossière qu'une résolution d'impression du système d'impression 3D,
dans lequel la ou les structures de soutien améliorées sont définies de telle sorte qu'elles occupent moins d'espace sur un plateau de fabrication du système d'impression 3D que la ou les structures de soutien par défaut et/ou nécessitent moins de matériau de soutien que la ou les structures de soutien par défaut,
dans lequel la définition de la ou des structures de soutien améliorées comprend les étapes consistant à :
sélectionner un sous-ensemble de tranches précédentes des multiples tranches qui précèdent la ou les tranches identifiées, dans lequel chacune des tranches du sous-ensemble de tranches précédentes doit inclure au moins une région de soutien à remplir avec un matériau de soutien lors de l'impression du ou des objets 3D, pour former ainsi la ou les structures de soutien nécessaires pour soutenir la ou la région de corps dans la ou les tranches identifiées ; et
définir au moins une région de soutien pour chaque tranche du sous-ensemble de tranches précédentes de telle sorte qu'une largeur de la ou des régions de soutien du sous-ensemble de tranches précédentes augmente graduellement entre une dernière tranche du sous-ensemble qui est adjacente à la ou aux tranches identifiées et une première tranche du sous-ensemble.

2. Procédé selon la revendication 1, dans lequel la détermination que la ou les régions de corps de la ou des tranches identifiées répondent à l'ensemble prédéfini de règles comprend les étapes consistant à :
déterminer qu'une largeur de la ou des régions de corps dans la ou les tranches identifiées est plus petite qu'un seuil de largeur spécifié.

3. Procédé selon l'une quelconque des revendications 1 à 2, dans lequel la détermination que la ou les régions de corps dans la ou les tranches identifiées répondent à l'ensemble prédéfini de règles comprend l'étape consistant à :
déterminer qu'une distance entre la ou les régions de corps dans la ou les tranches identifiées et au moins une région de corps dans l'une des tranches précédentes immédiatement en dessous de la ou des régions de corps dans la ou les tranches identifiées ou le plateau de fabrication est plus large qu'un seuil de distance spécifié.

4. Procédé selon l'une quelconque des revendications 1 à 3, dans lequel la détermination que la ou les régions de corps dans la ou les tranches identifiées répondent à l'ensemble prédéfini de règles comprend l'étape consistant à :
déterminer qu'une longueur de la ou des régions de corps dans la ou les tranches identifiées est plus grande qu'un seuil de longueur spécifié.

5. Procédé selon l'une quelconque des revendications 1 à 4, dans lequel la détermination que la ou les régions de corps dans la ou les tranches identifiées répondent à l'ensemble prédéfini de règles comprend l'étape consistant à :
déterminer qu'il n'y a aucune région de corps dans la ou les tranches subséquentes à la ou aux tranches identifiées qui soit plus large que la ou les régions de corps dans la ou les tranches identifiées.

6. Procédé selon l'une quelconque des revendications 1 à 5, comprenant les étapes consistant à :
déterminer si la ou les structures de soutien améliorées définies pour le pou les objets 3D obstruent la construction d'au moins un autre objet 3D sur le plateau de fabrication ; et
si c'est le cas, modifier un emplacement d'un ou plusieurs du ou des objets 3D et du ou des autres objets 3D sur le plateau de fabrication pour éviter son obstruction.

7. Système pour la définition d'au moins une structure de soutien pour au moins un objet 3D à imprimer en utilisant un système d'impression 3D, le système comprenant :
un module de découpage configuré pour :
recevoir un modèle numérique 3D d'au moins un objet 3D à imprimer; et
découper le modèle numérique 3D pour générer un ensemble de données numériques 3D comprenant des tranches multiples, dans lequel chacune d'au moins quelques-unes des tranches multiples comprend au moins une région de corps qui représente une section transversale horizontale respective du ou des objets 3D ; et
un module de définition de structure de soutien configuré pour :
identifier au moins une tranche des tranches multiples qui comprend au moins une région de corps qui doit être soutenue par au moins une structure de soutien lors de l'impression du ou des objets 3D ;
déterminer si la ou les régions de corps dans la ou les tranches identifiées répondent à un ensemble prédéfini de règles ;
si la ou les régions de corps dans la ou les tranches identifiées répondent à l'ensemble prédéfini de règles, définir au moins une structure de soutien par défaut pour la ou les régions de corps dans la ou les tranches identifiées ; et
si la ou les régions de corps dans la ou les tranches identifiées répondent à l'ensemble prédéfini de règles, définir au moins une structure de soutien améliorée pour la ou les régions de corps dans la ou les tranches identifiées,
dans lequel la ou les structures de soutien par défaut et la ou les structures de soutien améliorées sont définies en utilisant une résolution de l'ensemble de données numériques 3D qui est plus grossière qu'une résolution d'impression du système d'impression 3D,
dans lequel la ou les structures de soutien améliorées sont définies de telle sorte qu'elles occupent moins d'espace sur un plateau de fabrication du système d'impression 3D que la ou les structures de soutien par défaut et/ou nécessitent moins de matériau de soutien que la ou les structures de soutien par défaut,
dans lequel, pour définir la ou des structures de soutien améliorées, le module de définition de structure de soutien est configuré pour :
sélectionner un sous-ensemble de tranches précédentes des multiples tranches qui précèdent la ou les tranches identifiées, dans lequel chacune des tranches du sous-ensemble de tranches précédentes doit inclure au moins une région de soutien à remplir avec un matériau de soutien lors de l'impression du ou des objets 3D, pour former ainsi la ou les structures de soutien nécessaires pour soutenir la ou la région de corps dans la ou les tranches identifiées ; et
définir au moins une région de soutien pour chaque tranche du sous-ensemble de tranches précédentes de telle sorte qu'une largeur de la ou des régions de soutien du sous-ensemble de tranches précédentes augmente graduellement entre une dernière tranche du sous-ensemble qui est adjacente à la ou aux tranches identifiées et une première tranche du sous-ensemble.

8. Système selon la revendication 7, dans lequel, pour déterminer que la ou les régions de corps dans la ou les tranches identifiées répondent à l'ensemble prédéfini de règles, le module de définition de structure de soutien est configuré pour :
déterminer qu'une largeur de la ou des régions de corps dans la ou les tranches identifiées est plus petite qu'un seuil de largeur spécifié.

9. Système selon l'une quelconque des revendications 7 à 8, dans lequel, pour déterminer que la ou les régions de corps dans la ou les tranches identifiées répondent à l'ensemble prédéfini de règles, le module de définition de structure de soutien est configuré pour :
déterminer qu'une distance entre la ou les régions de corps dans la ou les tranches identifiées et au moins une région de corps dans l'une des tranches précédentes immédiatement en dessous de la ou des régions de corps dans la ou les tranches identifiées ou le plateau de fabrication est plus large qu'un seuil de distance spécifié.

10. Système selon l'une quelconque des revendications 7 à 9, dans lequel, pour déterminer que la ou les régions de corps dans la ou les tranches identifiées répondent à l'ensemble prédéfini de règles, le module de définition de structure de soutien est configuré pour :
déterminer qu'une longueur de la ou des régions de corps dans la ou les tranches identifiées est plus grande qu'un seuil de longueur spécifié.

11. Système selon l'une quelconque des revendications 7 à 10, dans lequel, pour déterminer que la ou les régions de corps dans la ou les tranches identifiées répondent à l'ensemble prédéfini de règles, le module de définition de structure de soutien est configuré pour :
déterminer qu'il n'y a aucune région de corps dans la ou les tranches subséquentes à la ou aux tranches identifiées qui soit plus large que la ou les régions de corps dans la ou les tranches identifiées.

12. Système selon l'une quelconque des revendications 7 à 11, dans lequel le module de découpage est configuré pour :
déterminer si la ou les structures de soutien améliorées définies pour le pou les objets 3D obstruent la construction d'au moins un autre objet 3D sur le plateau de fabrication ; et
si c'est le cas, modifier un emplacement d'un ou plusieurs du ou des objets 3D et du ou des autres objets 3D sur le plateau de fabrication pour éviter son obstruction.
